# EUROPÄISCHE PATENTSCHRIFT

(11) **EP 0 424 626 B1**
(45) Veröffentlichungstag und Bekanntmachung des Hinweises auf die Patenterteilung: **08.05.1996**
(21) Anmeldenummer: 90115931.9
(22) Anmeldetag: 20.08.1990
(51) Int. Cl.: H05K 9/00

(54) **Abschirmung gegen elektromagnetische Wellen, elektrische Pulse und/oder elektrische Strahlung für Öffnungen, vorzugsweise für Fensteröffnungen, von abgeschirmten Räumen**
Openings shield against electromagnetic waves electric pulses and/or electric rays, preferably for window openings of shielded enclosures
Blindage contre les ondes électromagnétiques, les impulsions et le rayonnement électriques des ouvertures, de préférence, de fenêtre de locaux blindés

(30) Priorität: 24.10.1989 DE 3935409
(43) Veröffentlichungstag der Anmeldung: 02.05.1991
(73) Patentinhaber: Alfred Kunz GmbH & Co., D-80336 München (DE)
(72) Erfinder: Pallor, Hans Fritz, Dipl.-Ing., D-6800 Mannheim 1 (DE)
(74) Vertreter: Gossel, Hans K., Dipl.-Ing.

(56) Entgegenhaltungen:
- EP-A- 0 304 612
- DE-U- 8 910 698
- GB-A- 922 352
- BAUTEILE REPORT SIEMENS. Bd. 15, Nr. 4, August 1977, MUNCHEN DE Seiten 147 -152; ULRICH POHL: 'Raumabschirmungen im Allgemeinen Krankenhaus Wien'

## Beschreibung

Die Erfingung betrifft eine Abschirmungsanordnung gegen elektromagnetische Wellen, elektrische Pulse und/oder elektrische Strahlung für Öffnungen, vorzugsweise für Fensteröffnungen, von abgeschirmten Räumen, bestehend aus mindestens einer leitenden Schicht, die mit einer leitenden Einfassung der Öffnung leitend verbunden ist.

Für viele Zwecke werden Räume benötigt, die gegenüber elektromagnetischen Wellen, elektrischen Pulsen und elektrischer Strahlung sicher abgeschirmt sind und somit eine Dämpfung frequenzabhängiger Störstrahlungen im Nieder- und Hochfrequenzbereich besitzen.

Eine Abschirmung insbesondere gegenüber hochfrequenten elektromagnetischen Wellen ist beispielsweise notwendig, um Räume abhörsicher zu machen. Diese Abhörsicherheit bezieht sich nicht nur auf gesprochene Worte, sondern auch auf dem Informationsaustausch dienende elektrische und elektronische Geräte.

Beispielsweise besteht die Möglichkeit, die digitale Steuerung einer elektrischen Schreibmaschine abzuhören. Die Notwendigkeit einer Abschirmung besteht nicht nur bei Räumen, in denen sensible Informationen ausgetauscht werden, sondern auch zum Schutz empfindlicher elektrischer und elektronischer Geräte. Beispielsweise können Geräte zur Gehirnstrommessung und für kardiologische Untersuchungen und Behandlungen durch Störfrequenzen und Störimpulse bis zur Funktionsunfähigkeit gestört und beeinträchtigt werden. Im militärischen Bereich und im zivilen Bereich, beispielsweise für Banken, Versicherungen und Kliniken, besteht daher ein Bedarf an geschirmten Räumen.

Während die Schirmung der Wände, Böden und Decken durch fugenlose Auskleidung mit Schirmendämmaterial, beispielsweise mit Blechen der erforderlichen Permeabilität, problemlos vorgenommen werden kann, ist die Schirmung kontrollierter Durchdringungen, wie Türen und Fenster sowie Durchführungen für Versorgungsleitungen, schwierig. Besonders problematisch ist die schirmungsdichte Verkleidung von Öffnungen, wie Fensteröffnungen, da diese nur vorübergehend benötigt wird und außerhalb der geschirmten Zeiträume die Öffnungen durchsichtig oder sogar durchgängig sein sollen, so daß sich durch die nur vorübergehende Anordnung der Abschirmungen schirmungsundichte Leckstellen ergeben können.

Um Fenster zu schirmen, ist es bekannt, sandwichartig Pakete aus Glasscheiben vorzusehen, zwischen die Metallgewebe eingelegt sind und die zusätzlich auch bedampft sein können. Da derartige Glasscheibenpakete Dicken bis zu 30 cm bis 40 cm aufweisen können, weisen sie nur noch eine geringe Transparenz auf, die beispielsweise im Bereich von 30 % liegt. Bei derartigen schirmenden Glasscheibenpaketen stellt sich ein sogenannter BienenwabenEffekt ein, aufgrund dessen die Außenwelt in gerasteter Form und zusätzlich milchig getrübt erscheint. Die

Glasscheibenpakete können zusätzlich mit mit flüssigem und/oder gasförmigen Medien gefüllten Kammern versehen sein, was deren Anordnung weiterhin erschwert.

Abgesehen von dem erheblichen Aufwand zum Einbau derartiger aus Glasscheibenpaketen bestehender schirmender Fenster und der mit diesen verbundenen Lichteinbuße hat ein längerer Aufenthalt von Personen in mit derartigen geschirmten Fenstern versehenen Räumen nachteilige psychologische Wirkungen, weil die verschleierte Sicht durch die abgeschirmten Fenster zunehmend unerträglicher wird.

Aufgabe der Erfindung ist es daher, eine Abschirmungsanordnung der eingangs angegebenen Art zu schaffen, die sich baulich in wirtschaftlicher Weise herstellen und in der Weise einfach handhaben läßt, daß sie bei Bedarf schnell aktiviert und eingerichtet werden kann und sich anschließend wieder entfernen läßt, so daß die Öffnungen oder Fenster wieder frei durchgängig oder durchsichtig sind. Die Abschirmung soll sich auch nachträglich in vorhandene Gebäudeteile einbringen lassen.

Erfindungsgemäß wird diese Aufgabe bei einer Abschirmungsanordnung der gattungsgemäßen Art durch die kennzeichnenden Merkmale des Patentanspruchs 1 gelöst.

Die erfindungsgemäße Abschirmungsanordnung ist in ihrer schirmenden Stellung leitend und schirmungsdicht über den Kontaktrahmen mit der Schirmung der Wandung des abzuschirmenden Raumes verbunden. Die erfindungsgemäße Schirmung schließt den abgeschirmten Raum nach dem Grundprinzip des Faradaykäfig schirmungsdicht ab. Ein mit der erfindungsgemäßen Abschirmung versehener Raum ist gegen Beeinflussung elektromagnetischer Wellen oder elektrischer Pulse von außen abgeschirmt. Weiterhin können elektromagnetische Wellen oder elektrische Pulse auch nicht von innen nach außen dringen.

Aus EP-A-0 304 612 ist eine Abdeckung zur elektromagnetischen Abschirmung von Fenster- und Türöffnungen bekannt, die aus zwei ineinanderliegenden Wannen aus einem elektromagnetisch leitenden Material besteht, wobei die Wannenböden über Abstandselemente miteinander verbunden einen Hohlraum und die Wannenseiten einen umlaufenden Schacht bilden.

Der Schirmungsbehang oder das Blatt aus schirmendem Material kann flexibel oder aber auch plattenförmig sein.

Die erfindungsgemäße Abschirmungsanordnung läßt sich in unterschiedlicher Weise schirmungsdicht in die Öffnungen einfügen.

Nach einer ersten Ausführungsform ist vorgesehen, daß ein flexibler Schirmungsbehang auf eine oberhalb der Tür gelagerte Wickelwelle aufwickelbar und von dieser abwickelbar ist und daß der abgewickelte Schirmungsbehang durch den Anpreßrahmen klemmend gegen den Kontaktrahmen andrückbar ist. Bei dieser Ausführungsform läßt sich der Schirmungsbehang nach Art einer Jalousie oder eines Rollos auf eine Wickelwelle aufwickeln und von dieser abwickeln, wobei die Wickelwelle mit einem Antrieb oder einer Torsionsfeder versehen sein kann, die diese beim Abziehen des Schirmungsbehanges zusätzlich in Aufwickelvorrichtung vorspannt, so daß die vorgespannte Feder in der Lage ist, den Schirmungsbehang auch wieder auf die Wickelwelle aufzuwickeln. Der Anpreßrahmen kann auf Führungszapfen des Kontaktrahmens, die Bohrungen des Anpreßrahmens durchsetzen, geführt und durch eine Spanneinrichtung gegen den auf dem Kontaktrahmen abgestützten Schirmungsbehang andrückbar sein. Dabei drückt die Spanneinrichtung den Anpreßrahmen mit so großem Druck gegen den Kontaktrahmen an, daß der Schirmungsbehang gut leitend mit dem Kontaktrahmen verbunden ist. Die Spanneinrichtung kann bekannter Art sein und aus einer Exzenter oder Knebel oder Kniehebelspanneinrichtung bestehen.

Zweckmäßigerweise sind der Kontaktrahmen und der Anpreßrahmen mit umlaufenden federnden Kontaktleisten versehen, die in Draufsicht miteinander fluchten. Diese Kontaktleisten gewährleisten eine gute Kontaktierung, so daß unerwünschte Leckstellen ausgeschlossen sind.

Nach einer anderen Ausführungsform der erfindungsgemäßen Abschirmungsanordnung ist vorgesehen, daß der Anpreßrahmen leitend mit einer aus dem Schirmungsbehang bestehenden Bespannung und mit einer umlaufenden, zum Kontaktrahmen hin offenen Nut versehen ist, die auf einen umlaufenden Steg des Kontaktrahmens aufsetzbar ist, und daß an den in die Nut eingeführten Steg an den Flanken der Nut angebrachte federnde Kontaktleisten mit Vorspannung anliegen. Der mit der Bespannung versehene Anpreßrahmen kann im Bereich eines Randes der Öffnung an der Wand des Raumes durch Scharnierbänder angelenkt sein. Diese Scharnierbänder sind in weiterer Ausgestaltung der Erfindung so ausgestaltet, daß sich der Anpreßrahmen parallel zu sich selbst und zu dem Kontaktrahmen gegen diesen andrücken läßt.

Nach einer weiteren Ausführungsform der erfindungsgemäßen Abschirmungsanordnung ist vorgesehen, daß der leitend mit einer aus dem Schirmungsbehang bestehenden Spannung versehene Anpreßrahmen in eine Aussparung der Wand oberhalb oder unterhalb der Öffnung nach Art eines Schiebefensters versenkbar und mit Vorsprüngen mit keilförmigen Schrägflächen versehen ist, die sich auf komplementäre keilförmige Schrägflächen des Kontaktrahmens oder der Wand derart abstützen, daß der Anpreßrahmen und der Kontaktrahmen unter Schwerkraftwirkung gegeneinander gedrückt werden. Auch bei dieser Ausführungsform kann die Kontaktierung dadurch verbessert werden, daß der Kontaktrahmen und/oder der Anpreßrahmen umlaufend mit federnden Kontaktleisten versehen sind.

Nach einer weiteren Ausführungsform der erfindungsgemäßen Abschirmungsanordnung ist vorgesehen, daß der mit einer aus dem Schirmungsbehang bestehenden Bespannung versehene Anpreßrahmen in zueinander parallelen Führungsschienen der Wandung, die zwischen sich die Öffnung einschließen, zwischen einer oberhalb oder unterhalb der Öffnung und einer die Öffnung abdeckenden Stellung verschieblich geführt ist. Diese Ausgestaltung nach Art eines Kippfensters oder Kipptores ermöglicht eine einfache Handhabung. Die Führungsschienen können sich bis in den Deckenbereich erstrecken, so daß der Anpreßrahmen in eine inaktive zu der Decke des Raumes parallele Stellung verschiebbar ist.

Der Anpreßrahmen kann durch Rollen oder Gleitsteine in einer Führung mit im wesentlichen rechteckigem Profil geführt sein, daß mit einem Schlitz für die die Rollen oder Gleitsteine tragenden Zapfen versehen ist, wobei der Anpreßrahmen mit seitlichen Kontaktfederleisten versehen ist, die auf dem Führungsprofil gleiten.

Die Kontaktleisten bestehen zweckmäßigerweise aus nebeneinanderliegenden federnden Kontaktlamellen aus schirmendem Material mit mittleren bogenförmig gekrümmten Teilen. Die Kontaktlamellen können nur mit einer Seite an dem diese tragenden Rahmen oder Profil verbunden sein, so daß die anderen Seiten unter dem Andruck federnd ausweichen können.

Die Kontaktleisten können auch aus Schläuchen oder Rundprofilen mit Mänteln aus Drahtgeflecht o.dgl. bestehen, die zusätzlich aufblasbar sein können.

Der Kontaktrahmen und der Anpreßrahmen bestehen zweckmäßigerweise aus Chromnickelstahl, wie V2A- oder V4A-Stahl oder aus Kupfer oder Kupferlegierungen.

Die Rahmenkonstruktionen bestehen zweckmäßigerweise aus Profilen, die unter Schutzgas miteinander verschweißt sind. Die Rahmenschenkel können im Preß-Streckverfahren mit federnden Kontaktleistenabschnitten versehen sein.

Der Schirmungsbehang besteht in weiterer Ausgestaltung der Erfindung aus einem Gewebe, einem Gewirke oder einem textilen Blatt aus Glasfasern, Kunststoffäden und/oder Draht, die ein-oder beidseitig mit einem Pulver und/oder Granulat aus Schirmungsmaterial beschichtet sind. Dabei wird die Beschichtung zweckmäßigerweise im Flammspritzverfahren aufgebracht. Die Beschichtung kann auch durch einen mit dem Granulat oder Pulver vermischten Kleber auf Kunststoffbasis aufgebracht sein, der seinerseits eine gute Leitfähigkeit besitzt. Das Schirmungsmaterial besteht zweckmäßigerweise aus Chromnickelstahl, Kupfer oder V2A- oder V4A-Stahl und/oder Alugranulat.

Das in ungleichmäßiger und gleichsam zerklüfteter Form aufgebrachte pulverisiert oder granulierte Schirmungsmaterial hat neben seiner dämpfenden Wirkung zusätzlich auch noch einen weiteren absorbierenden Effekt, der sich daraus ergibt, daß die Strahlung in unterschiedliche Richtungen reflektiert wird, was zu einer zusätzlichen Absorption im Gegensatz zu glatten Blechen führt, bei denen sich im wesentlichen nur eine Reflektionsrichtung einstellt.

Besonders wichtig ist, daß das Schirmungsmaterial bei bestimmten Anwendungsfällen a-magnetisch ist. Beispielsweise lassen sich Kernspintomografen störungsfrei nur mit amagnetischen Abschirmungen betreiben, da sich andernfalls zu Störungen führende Rückwirkungen einstellen würden.

Als Schirmungsmaterial zur Beschichtung der Trägerbahnen kommen grundsätzlich alle Materialien mit geeigneter Permeabilität in Betracht.

Da die Beschichtungen abriebgefährdet sind, werden zweckmäßigerweise äußere Schutzschichten aus leitendem Lack oder Kunststoff vorgesehen, die eine ausreichende Verschließfestigkeit gewähren.

In weiterer Ausgestaltung der Erfindung sind mindestens zwei im Abstand voneinander vorgesehene Schirmungsschichten aus unterschiedlichem Schirmungsmaterial vorgesehen, die gegeneinander isoliert sind. Die Dämpfungswirkung wird verbessert, wenn die Schichten unterschiedliche Permeabilitäten aufweisen. Um zwei Schirmungsschichten zu schaffen, kann der Anpreßrahmen beidseits mit Bespannungen aus schirmendem Material versehen sein.

Die Anpreßrahmen können mit schirmenden Folien oder Behängen bespannt sein. Sie können aber auch Bleche aus schirmendem Material tragen.

Ausführungsbeispiele der Erfindung werden nachstehend anhand der Zeichnung näher erläutert. In dieser zeigt
- Fig. 1: eine Draufsicht auf ein Fenster, das durch einen von einer rolloartigen Wickelwelle abgezogenen Schirmungsbehang geschirmt ist, der durch einen aufgesetzten Anpreßrahmen gegen einen Kontaktrahmen angedrückt ist,
- Fig. 2: einen vertikalen Schnitt durch das Fenster nach Fig. 1,
- Fig. 3: einen Schnitt durch das Fenster längs der Linie III-III in Fig. 1,
- Fig. 4: eine der Fig. 3entsprechende Darstellung des Fensters vor dem spannenden Andruck des Anpreßrahmens gegen den Kontaktrahmen,
- Fig. 5: eine Draufsicht auf ein Fenster mit einem an der Wandung durch Scharnierbänder angelenkten Anpreßrahmen,
- Fig. 6: einen horizontalen Schnitt durch das Fenster nach Fig. 5,
- Fig. 7: eine vergrößerte Darstellung des Fig. 6 eingekreisten Scharnierbandes,
- Fig. 8: eine vergrößerte Darstellung der aufeinanderliegenden Rahmenteile gemäß Detail B in Fig. 6,
- Fig. 9: eine der Fig. 7 entsprechende Darstellung eines Scharniers vor dem Aufschieben des Anpreßrahmens auf den Kontaktrahmen,
- Fig. 10: eine der Fig. 7 entsprechende Darstellung mit teilweise abgeschwenktem Anpreßrahmen,
- Fig. 11: eine der Fig. 7 entsprechende Darstellung mit um 90° verschwenktem Kontaktrahmen,
- Fig. 12: einen Schnitt durch einen Scharnierteil,
- Fig. 13: einen Vertikalschnitt durch ein Fenster mit einem schiebefensterartig versenkbaren Anpreßrahmen,
- Fig. 14: eine der Fig. 13 entsprechende Darstellung in der Schirmungsstellung des Anpreßrahmens,

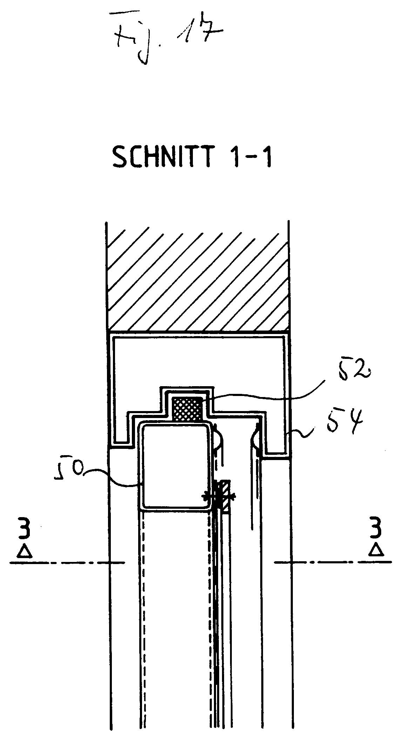

- Fig. 15: einen Schnitt durch das Fenster längs der Linie 3-3 in Fig. 17,

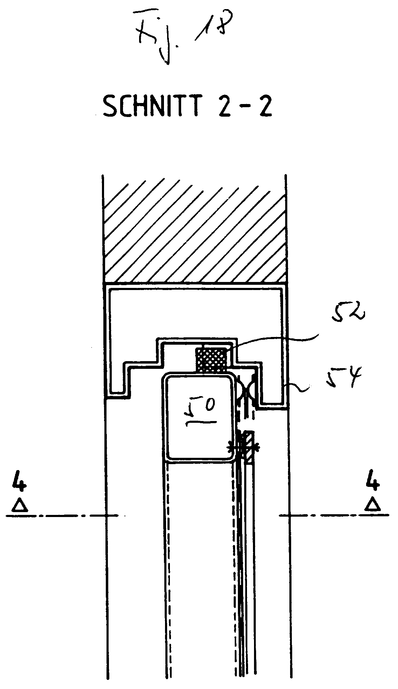

- Fig. 16: einen Schnitt durch das Fenster längs der Linie 4-4 in Fig. 18,
- Fig. 17: einen Schnitt durch das Fenster längs der Linie 1-1 in Fig. 15,
- Fig. 18: einen Schnitt durch das Fenster längs der Linie 2-2 in Fig. 16,
- Fig. 19: eine Draufsicht auf ein Fenster mit einem in Verschiebeführungen angeordneten Kontaktrahmen,
- Fig. 20: einen Vertikalschnitt durch die Fensteranordnung nach Fig. 19 und
- Fig. 21: einen Schnitt durch das Fenster längs der Linie XXI-XXI in Fig. 19.

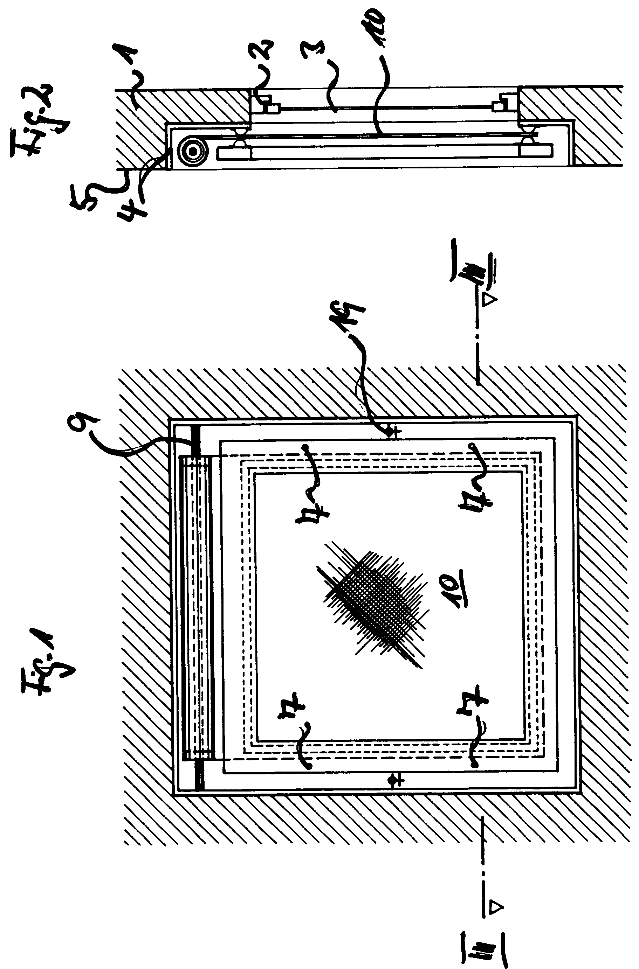

Bei der Ausführungsform eines geschirmten Fensters nach den Fig. 1 bis 4 ist in eine Wandung 1 eines Raumes in üblicher Weise in einem rechteckigen Durchbruch ein in einem Rahmen 2 gehaltertes Fenster 3 angeordnet. Die Wandung 1 ist auf ihrer Innenseite mit einem umlaufenden stufenförmigen Absatz versehen, der durch einen Kontaktrahmen 4 mit winkeligen Rahmenprofilen ausgekleidet ist. Der Kontaktrahmen 4 besteht aus schirmendem Material, und zwar vorzugsweise aus unmagnetischem Metall, wie Chromnickelstahl oder Kupfer. Die senkrecht zu der Wand 1 stehenden Rahmenschenkel sind umlaufend mit der schirmenden Plattierung 5 des Raumes leitend verbunden. Die innenliegenden, zu der Wand 1 parallelen Schenkel 6 der Profile des Kontaktrahmens 4 sind mit vier senkrecht auf diesen stehenden Haltezapfen 7 versehen, die Bohrungen eines auf diese aufsetzbaren Anpreßrahmens 8 durchsetzen.

Oberhalb des Fensterdurchbruchs ist zwischen den seitlichen Profilen des Kontaktrahmens eine Wickelwelle 9 in bekannter und daher nicht näher dargestellter Weise drehbar gelagert, auf die eine Schirmungsbehang 10 aufwickelbar ist. Die Wickelwelle 9 ist in nicht dargestellter Weise mit einem Antrieb oder einer mit einer Feder versehenen Einrichtung zum Auf- und Abwickeln des Schirmungsbehanges 10 versehen.

Ist der Schirmungsbehang 10 in der aus den Fig. 1 bis 4 ersichtlichen Weise von der Wickelwelle 9 soweit abgezogen worden, daß sie die Fensteröffnung überdeckt, wird der Anpreßrahmen 8 unter Zwischenlage des Schirmungsbehanges 10 gegen den Kontaktrahmen 4 in der Weise angedrückt, daß der Schirmungsbehang allseitig gut leitend mit dem Kontaktrahmen verbunden ist. Der Anpreßrahmen 8 besteht aus in seinen Winkelbereichen miteinander verschweißten Kastenprofilen aus schirmendem Material und ist auf seiner Außenseite umlaufend mit Kontaktleisten 12 versehen. Diese Kontaktleisten 12 bestehen aus bogenförmig gekrümmten Mittelteilen 13 mit an diesen anschließenden in einer Ebene liegenden Schenkeln 14, 15, von denen mindestens ein Schenkel, vorzugsweise aber beide mit den Profilen verbunden sind. Um der Kontaktleisten gute federnde Eigenschaften zu verleihen, ist diese in Abständen mit parallelen Schnitten versehen, die diese lamellenartig unterteilen.

In Draufsicht fluchtend ist auch der Kontaktrahmen in entsprechender Weise mit umlaufenden federnden Kontaktleisten 16 versehen.

Zwischen dem Kontaktrahmen 4 und dem Anpreßrahmen 8 sind auf die Zapfen 7 Druckfedern 17 aufgesetzt, die bestrebt sind, die Rahmen auseinanderzudrücken.

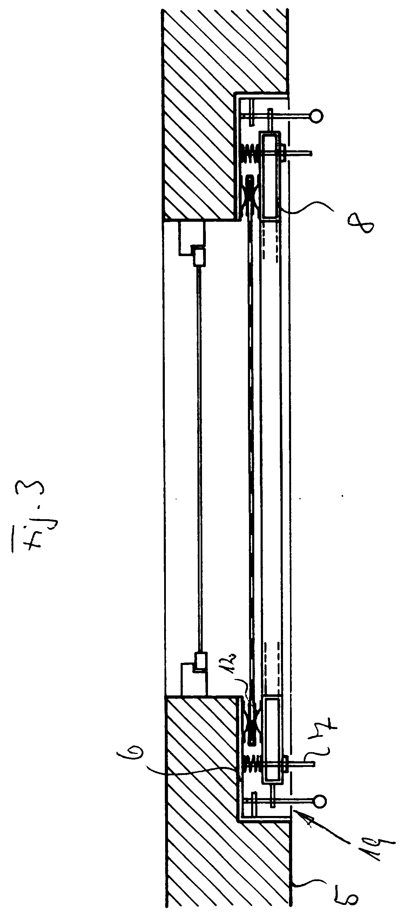

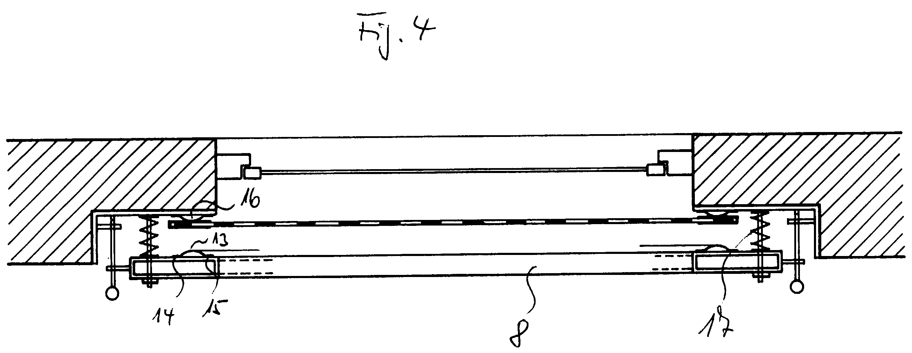

Zwischen dem Kontaktrahmen 4 und dem Anpreßrahmen 8 sind beispielsweise aus Knebeln oder Exzenter oder anderen Spannhebelanordnungen bestehende Spanneinrichtungen 19 vorgesehen, durch die der Anpreßrahmen 8 in der aus den Fig. 2 und 3 ersichtlichen Weise gegen den Kontaktrahmen 4 andrückbar ist.

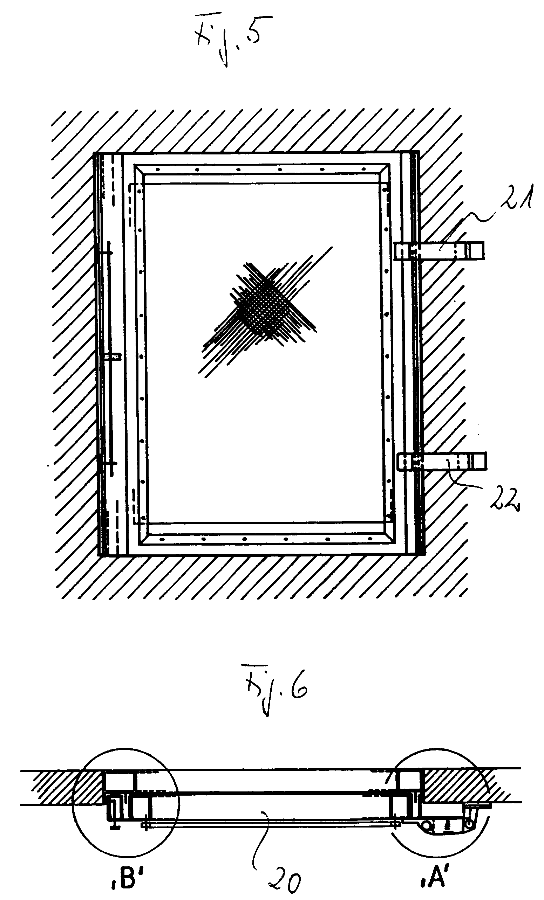

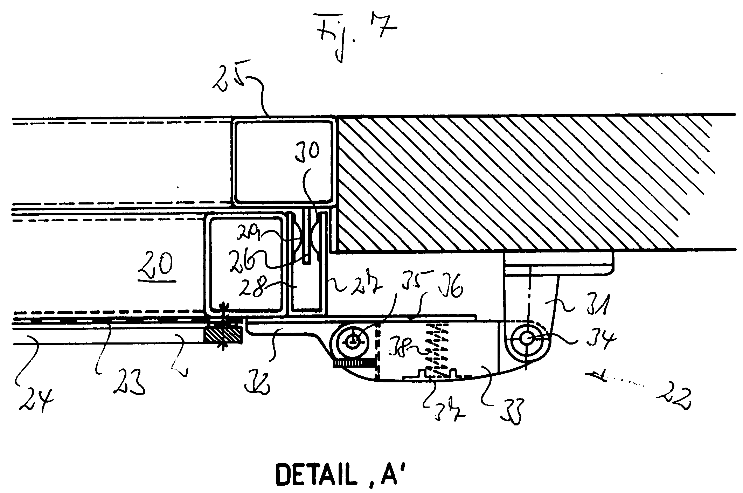

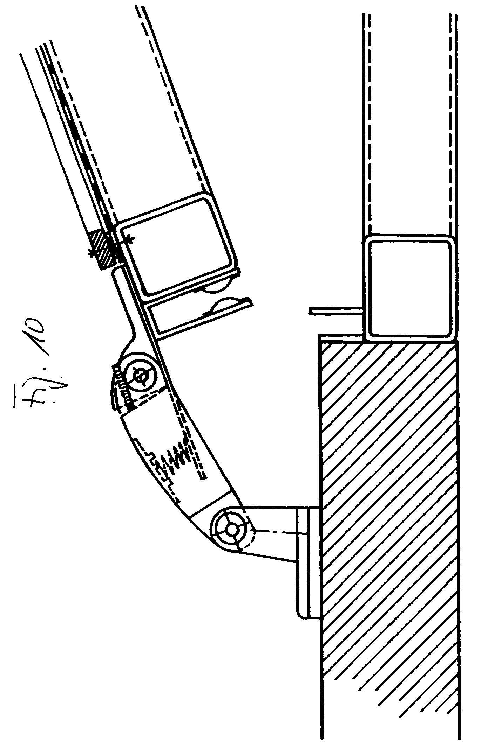

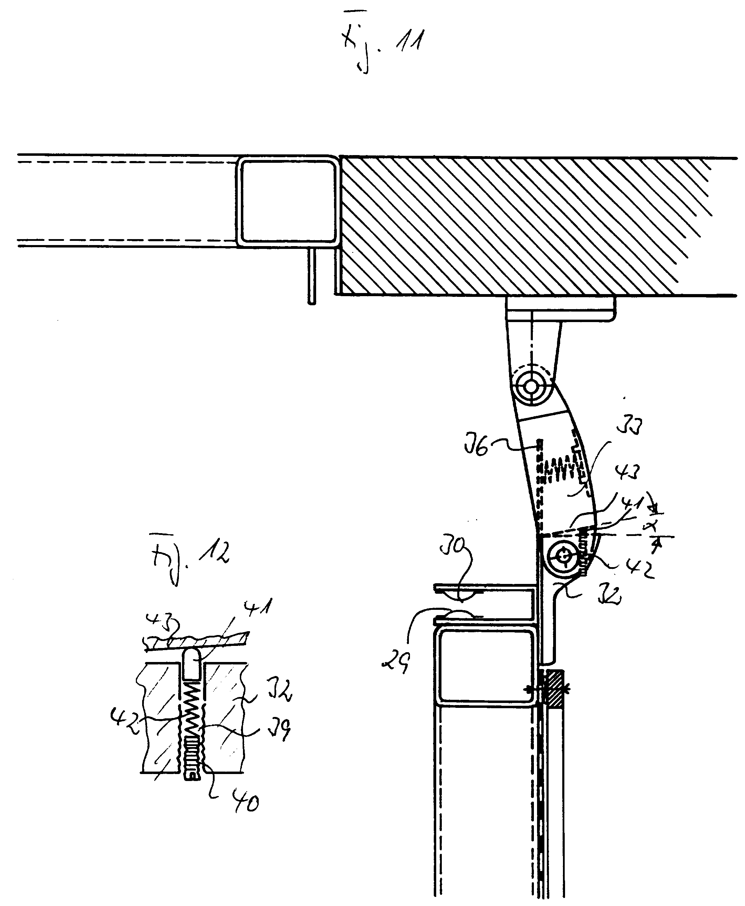

Bei der Ausführungsform nach den Fig. 5 bis 12 ist der Anpreßrahmen 20 durch Scharnierbänder 21, 22 mit der Wandung verbunden, so daß er wie ein Fensterladen als Schirmung vor die Fensteröffnung geschwenkt und mit gutem Kontakt mit dem Kontaktrahmen verbunden werden kann.

Der Ausdruck "Anpreßrahmen" wird auch für dieses zweite Ausführungsbeispiel beibehalten, obwohl bei diesem der Anpreßrahmen nicht gemäß dem Ausführungsbeispiel nach den Fig. 1 bis 4 gegen den Kontaktrahmen in einer Weise angedrückt wird, daß ein guter Kontakt gewährleistet ist. Vielmehr wird nach diesem Ausführungsbeispiel die Kontaktierung zwischen beiden Rahmen auf andere Weise erreicht.

Der Anpreßrahmen 20 ist auf seiner Innenseite mit einer Bespannung aus dem Schirmungsbehang 23 versehen. Der Schirmungsbehang ist dadurch mit dem aus einem Kastenprofil bestehenden Anpreßrahmen verbunden, daß die Profile unter Zwischenlage des Schirmungsbehanges 23 mit einem aufgeschraubten Spannrahmen 24 versehen sind.

Die innenliegenden Profilseiten des Kontaktrahmens 25 sind mit rechtwinkelig auf diesen stehenden umlaufenden Stegen 26 versehen. Diese Stege greifen in die durch mit den Rahmenprofilen des Anpreßrahmens 20 verbundene U-Profile 27 gebildete Nuten 28, wobei die inneren Flanken dieser Nuten 28 auf gegenüberliegenden Seiten mit Kontaktleisten 29, 30 versehen sind. Dabei ist die federnde Vorspannung der Kontaktleisten 30 so gewählt, daß diese mit einem guten Kontakt gewährleistenden Andruck gegen die Seiten der Stege 26 anliegen.

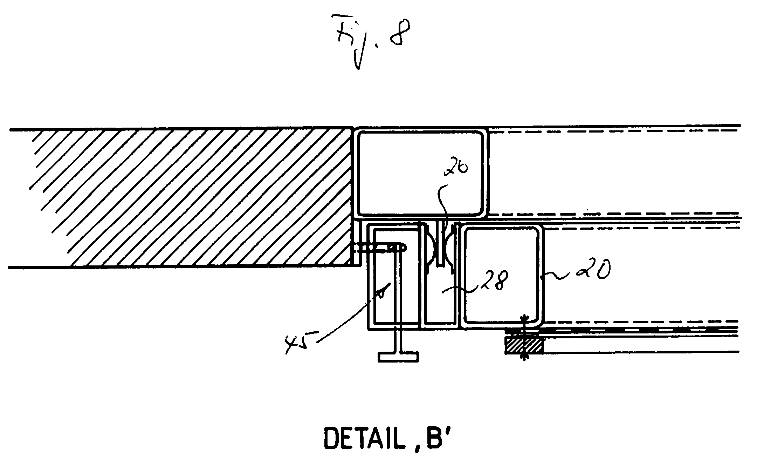

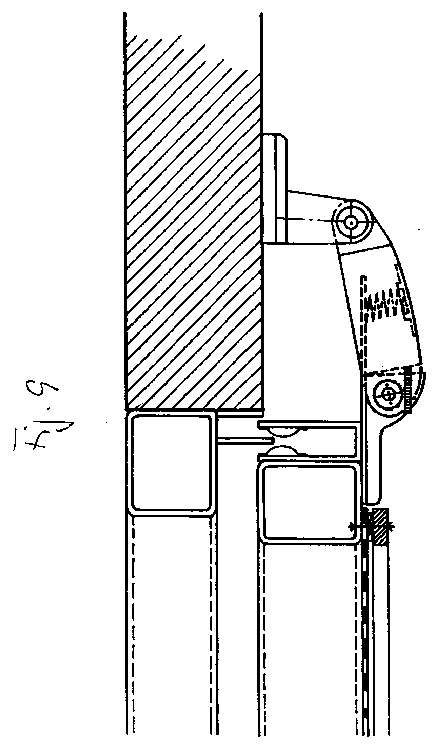

Aus den Fig. 7 bis 12 ist die Anlenkung des Anpreßrahmens 20 an der Wand seitlich der Fensteröffnung ersichtlich. Die Anlenkung erfolgt durch identisch ausgebildete Scharnierbänder 21, 22, von denen nachfolgend das Scharnierband 22 näher beschrieben wird. Das Scharnierband 22 besteht aus einem mit der Wand fest verbundenen Lagerteil 31, einem fest mit dem Anpreßrahmen 20 verbundenen beweglichen Lagerteil 32 und einem Lenker 33, der um die Gelenkbolzen 34, 35 schwenkbar gelenkig mit dem festen Scharnierteil 31 und dem beweglichen Scharnierteil 32 verbunden ist. Überkragend ist mit der inneren Seite des Profils des Anpreßrahmens 20 eine Stegplatte 36 verbunden, die sich bis über den mittleren Teil des Lenkers 33 erstreckt. Zwischen dieser überkragenden Stegplatte 36 und einem mit dem Lenker 33 verbundenen Widerlager 37 ist eine Druckfeder 38 mit Vorspannung eingespannt. Diese Druckfeder ist bestrebt, den Lenker 33 in seiner zu der Stegplatte 36 parallelen Lage zu halten. Wie insbesondere aus Fig. 12 ersichtlich ist, ist das bewegliche Scharnierteil 32 mit einer Bohrung 39 versehen, in der zwischen einer Magenschraube 40 und einem Bolzen 41 eine Druckfeder 42 eingespannt ist. Der Bolzen 41 stützt sich auf einer Widerlagerfläche 43 des Lenkers 33 in der Weise ab, daß die Kraft der Druckfeder 38 überwunden und der Lenker 33 zu der aus einer Stahlplatte bestehenden Stegplatte 36 eine um den Winkel abgewinkelte Stellung einnimmt. Dabei entspricht der Winkel wie aus Fig. 9 ersichtlich ist, der Abwinkelung, die erforderlich ist, um den Anpreßrahmen 20 unmittelbar vor der Schließstellung in eine zu der Ebene des Kontaktrahmens parallele Stellung zu verbringen. Wird nun der Anpreßrahmen 20 in der aus Fig. 9 ersichtlichen Stellung in die aus den Fig. 7 und 8 ersichtliche Schließstellung gedrückt, wird die Kraft der Druckfeder 42 überwunden und der Lenker 33 nimmt eine zu der Stegplatte 36 parallele Stellung ein.

Wie aus Fig. 8 ersichtlich ist, ist auf der den Scharnierbändern 21, 22 gegenüberliegenden Seite des Anpreßrahmens 20 eine Verriegelungseinrichtung 45 vorgesehen, die den Anpreßrahmen in seiner verriegelnden Kontaktstellung hält, in der der umlaufende Steg 26 in die Nut 28 greift und die Kontaktfedern 29, 30 unter Erzeugung des erforderlichen Kontaktdrucks auseinanderdrückt.

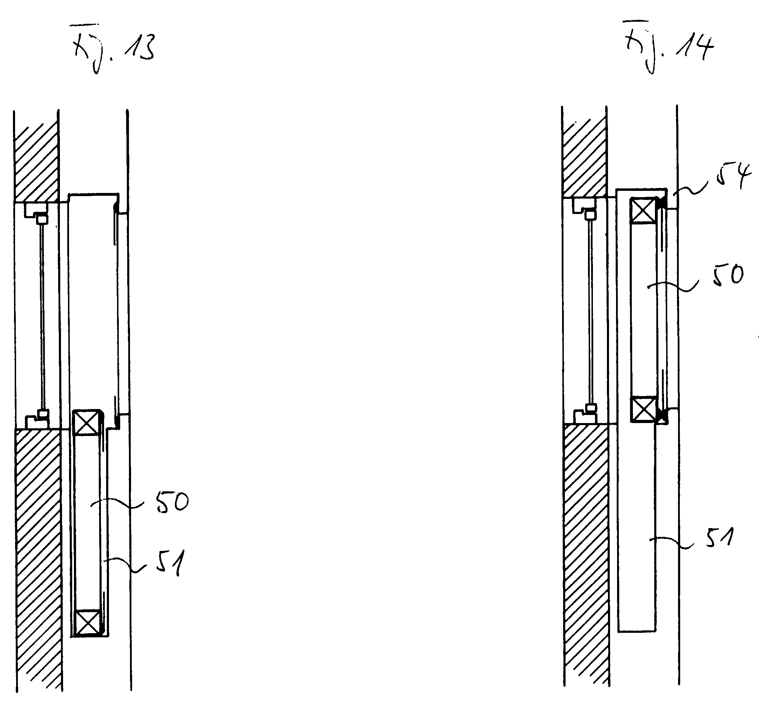

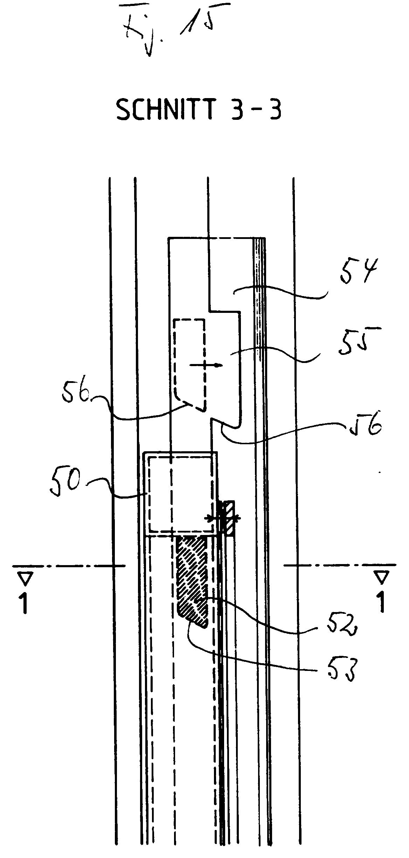

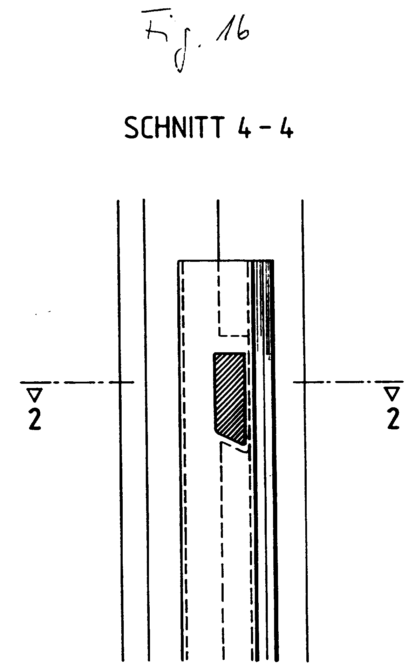

Bei dem Ausführungsbeispiel nach den Fig. 13 bis 16 ist der Anpreßrahmen 50 mit einer schiebefensterähnlichen Führung und Versenkung versehen. Der Kontaktrahmen 50, der in der beschriebenen Weise mit einer Bespannung aus dem Schirmungsbehang versehen ist, ist in der aus Fig. 13 ersichtlichen Weise in eine Aussparung 51 unterhalb der Fensteröffnung versenkbar und aus dieser in seine schirmende Stellung hebbar, die aus Fig. 14 ersichtlich ist. Der Kontaktrahmen 50 ist an den Außenseiten seiner seitlichen Holme jeweils in deren unteren und oberen Bereichen mit leistenartigen Fortsätzen 52 versehen, die auf ihren unteren Seiten in der aus der Zeichnung ersichtlichen Weise abgeschrägt Keilflächen 53 aufweisen. Der Kontaktrahmen 54 ist im Bereich der Oberseite und Unterseite der Fensteröffnung mit Aussparungen 55 versehen, deren unteren Seiten mit Schrägflächen 56 versehen sind, die zu den Schrägflächen 53 komplementär sind. Die Aussparungen 55 sind so lang, daß sich die leistenförmigen Vorsprünge 52 in diese einrücken lassen. Wird der Kontaktrahmen 50 nach dem Einrücken der Leisten 52 in die Aussparungen 55 freigegeben, legen sich die Schrägflächen 53, 56 aufeinander, so daß der Anpreßrahmen 50 in der aus Fig. 14 ersichtlichen Weise gegen den Kontaktrahmen 54 unter Schwerkraftwirkung angedrückt wird. Die Kontaktflächen sind dabei wiederum in der aus den Fig. 13 und 14 ersichtlichen Weise mit Federleisten versehen, so daß sich eine gut leitende Verbindung zwischen dem Anpreßrahmen und dem Kontaktrahmen ergibt.

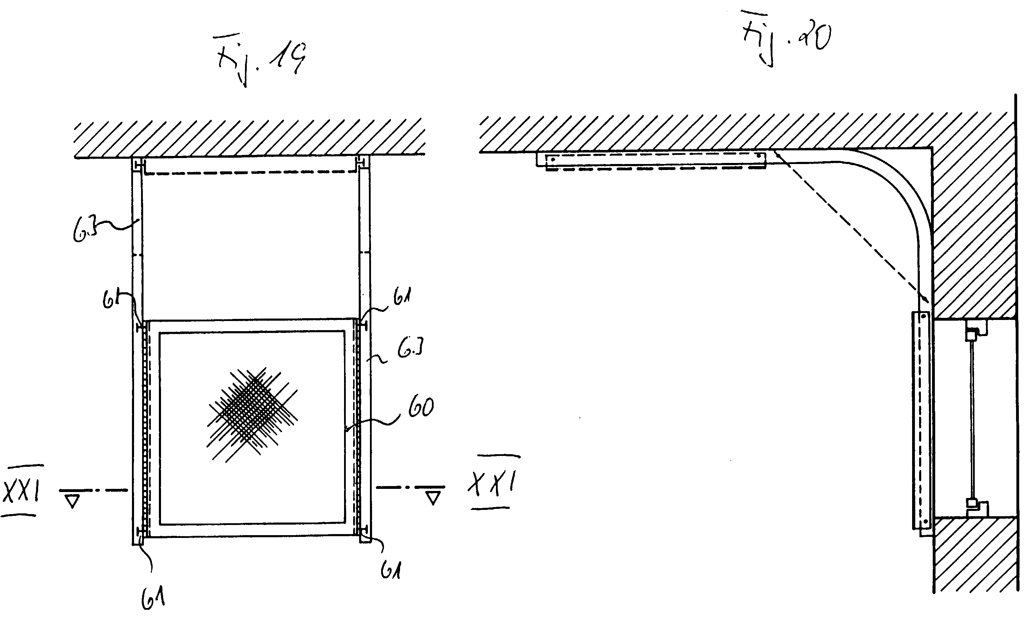

Bei dem Ausführungsbeispiel nach den Fig. 19 bis 21 ist eine kippfensterartige Führung für den Anpreßrahmen 60 vorgesehen, der in der beschriebenen Weise wiederum mit einer Bespannung aus einem Schirmungsbehang versehen ist. Die seitlichen Holme des Anpreßrahmens 60 sind mit Zapfen 61 versehen, auf denen Rollen 62 gelagert sind. Die Zapfen 61 greifen durch mittlere Schlitze von kastenförmigen Führungsprofilen 63, 64, die seitlich der Fensteröffnung angeordnet sind und über ein bogenförmig gekrümmtes Teil bis in den Deckenbereich des Raums verlaufen. Die kastenförmigen Profile 63, 64 bilden Führungsprofile für die Rollen 62, die in diesen laufen.

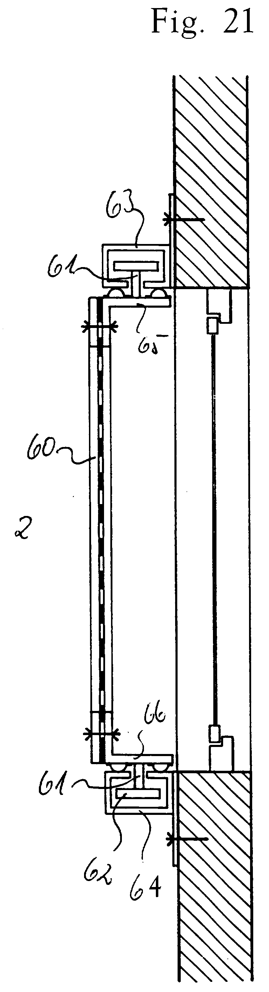

Die seitlichen Holme 65, 66 sind paarweise mit Kontaktfederleisten versehen, die in der aus Fig. 21 ersichtlichen Weise auf den Schenkeln der Führungsprofile 63, 64 beidseits des Schlitzes mit dem erforderlichen Andruck schleifen.

## Patentansprüche

1. Abschirmungsanordnung gegen elektromagnetische Wellen, elektrische Pulse und/oder elektrische Strahlung für Öffnungen vorzugsweise für Fensteröffnungen (3), von mittels einer Schirmung abgeschirmten Räumen, bestehend aus mindestens einer die Öffnung abdeckenden leitenden Schicht (10), die mit einer leitenden Einfassung (4) der Öffnung (3) leitend verbunden ist,
**dadurch gekennzeichnet,**
daß die Einfassung aus einem mit der Schirmung des Raumes leitend verbundenen Kontaktrahmen (4) besteht, daß ein gegen den Kontaktrahmen (4,54) durch eine Andrückeinrichtung (19) andrückbarer Anpreßrahmen (8,20,50) andrückbar ist und daß der Anpreßrahmen mit einem die leitende Schicht (10) bildenden Behang bzw. einem Blatt aus schirmendem Material bzw. mit einer schirmenden Beschichtung versehen ist oder daß der anpreßrahmen den die leitende Schicht (10) bildenden Behang (10,23) bzw. das die leitende Schicht (10) bildenden Blatt leitend an den Kontaktrahmen (4) andrückt.

2. Abschirmungsanordnung nach Anspruch 1, dadurch gekennzeichnet, daß die leitende Schicht (10) als flexibler Schirmungsbehang (10,23) ausgebildet ist, der auf eine oberhalb der Öffnung gelagerte Wickelwelle (9) aufwickelbar ist und der von dieser abwickelbar ist und daß der abgewickelte Schirmungsbehang (10,23) durch den Anpreßrahmen (8,20,50) klemmend gegen den Kontaktrahmen (4) andrückbar ist.

3. Abschirmungsanordnung nach Anspruch 2, dadurch gekennzeichnet, daß der Anpreßrahmen (8) auf Führungszapfen (7) des Kontaktrahmens (4), Bohrungen des Anpreßrahmens (8) durchsetzen, geführt und durch eine Spanneinrichtung (19) gegen den auf dem Kontaktrahmen (4) abgestützten Schirmungsbehang (10,23) andrückbar ist.

4. Abschirmungsanordnung nach einem der Ansprüche 1 bis 3, dadurch gekennzeichnet, daß der Kontaktrahmen (4) und der Anpreßrahmen (8) mit umlaufenden, federnden Kontaktleisten (12) versehen sind, die in Draufsicht miteinander fluchten.

5. Abschirmungsanordnung nach Anspruch 2, dadurch gekennzeichnet, daß der Anpreßrahmen (20) leitend mit einer aus dem Schirmungsbehang (10,23) bestehenden Bespannung und mit einer umlaufenden, zum Kontaktrahmen (25) hin offenen Nut (28) versehen ist, die auf einen umlaufenden Steg (26) des Kontaktrahmens (25) aufsetzbar ist, und daß an den in die Nut (28) eingeführten Steg (26) an den Flanken der Nut angebrachte, federnde Kontaktleisten (29, 30) mit Vorspannung anliegen.

6. Abschirmungsanordnung nach Anspruch 5, dadurch gekennzeichnet, daß der Anpreßrahmen (20) im Bereich eines Randes der Öffnung an der Wand des Raumes durch Scharnierbänder (21, 22) angelenkt ist.

7. Abschirmungsanordnung nach Anspruch 6, dadurch gekennzeichnet, daß die Scharnierbänder (21, 22) Lenker (33) aufweisen, die einerseits gelenkig mit der Wandung und andererseits gelenkig mit dem Anpreßrahmen (20) verbunden sind.

8. Abschirmungsanordnung nach Anspruch 7, dadurch gekennzeichnet, daß mit dem Anpreßrahmen (20) oder mit dem mit diesen verbundenen Gelenkteil (32) ein gegen das an der Wand befestigte Gelenkteil (31) gerichteter, steg- oder plattenförmiger Fortsatz (36) verbunden ist, zwischen dem und einem Widerlager (37) des Lenkers (33) eine Druckfeder (38) eingespannt ist, die bestrebt ist, den Lenker (33) in seine zu dem Anpreßrahmen (20) parallele Anschlagstellung zu verschwenken.

9. Abschirmungsanordnung nach Anspruch 7 oder 8, dadurch gekennzeichnet, daß in einer Bohrung (39) des mit dem Anpreßrahmen (20) verbundenen, beweglichen Scharnierteils (32) ein federbelasteter Bolzen (41) angeordnet ist, der sich auf eine Widerlagerfläche (43) des Lenkers (33) abstützt und der den Anpreßrahmen (20) um einen Winkel zu dem Lenker zu verschwenken trachtet, indem sich der Anpreßrahmen (20) unmittelbar vor seiner Schließstellung in einer parallelen Ebene zu dem Kontaktrahmen (25) befindet.

10. Abschirmungsanordnung nach Anspruch 1, dadurch gekennzeichnet, daß der leitend mit der aus dem Schirmungsbehang bestehenden Bespannung versehene Anpreßrahmen (50) in eine Aussparung (51) einer Wand oberhalb oder unterhalb der Öffnung nach Art eines Schiebefensters versenkbar und mit Vorsprüngen (52) mit keilförmigen Schrägflächen (53) versehen ist, die sich auf komplementäre, keilförmige Schrägflächen (56) des Kontaktrahmens (54) oder der Wand derart abstützen, daß der Anpreßrahmen (50) und der Kontaktrahmen (54) unter Schwerkraftwirkung gegeneinander gedrückt werden.

11. Abschirmungsanordnung nach Anspruch 10, dadurch gekennzeichnet, daß der Kontaktrahmen (54) und/oder der Anpreßrahmen (50) umlaufend mit federnden Kontaktleisten versehen sind.

12. Abschirmungsanordnung nach Anspruch 2, dadurch gekennzeichnet, daß der mit der aus dem Schirmungsbehang (10,23) bestehenden Bespannung versehene Anpreßrahmen (8,20,50) in zueinander parallelen Führungsschienen (63,64) der Wandung, die zwischen sich die Öffnung einschließen, zwischen einer oberhalb oder unterhalb der Öffnung und einer die Öffnung abdeckenden Stellung verschieblich geführt ist.

13. Abschirmungsanordnung nach Anspruch 12, dadurch gekennzeichnet, daß sich die Führungsschienen (63,64) bis in den Deckenbereich erstrecken, so daß der Anpreßrahmen in eine inaktive zu der Decke parallele Stellung verschiebbar ist.

14. Abschirmungsanordnung nach Anspruch 12 oder 13, dadurch gekennzeichnet, daß der Anpreßrahmen durch Rollen (61,62) oder Gleitsteine (61,62) in einer Führung (63,64) mit im wesentlichen rechteckigen Profil geführt ist, das mit Schlitzen für die Rollen oder Gleitsteine tragenden Zapfen versehen ist, und daß der Anpreßrahmen mit seitlichen Kontaktfederleisten (65,66) versehen ist, die auf dem Führungsprofil schleifen.

15. Abschirmungsanordnung nach einem der vorhergehenden Ansprüche, dadurch gekennzeichnet, daß die Kontaktfederleisten (65,66) aus nebeneinanderliegenden federnden Kontaktlamellen aus schirmendem Material mit mittleren bogenförmig gekrümmten Teilen bestehen.

16. Abschirmungsanordnung nach einem der Ansprüche 1 bis 14, dadurch gekennzeichnet, daß die Kontaktfederleisten (65,66) aus Schläuchen oder Rundprofilen mit Mänteln aus Drahtgeflecht bestehen.

17. Abschirmungsanordnung nach einem der Ansprüche 1 bis 16, dadurch gekennzeichnet, daß der Schirmungsbehang (10,23) aus einem Gewebe, einem Gewirke oder einem textilen Blatt aus Glasfasern, Kunststoffedern und/oder Draht besteht, die ein- oder beidseitig mit einem Pulver und/oder Granulat aus Schirmungsmaterial beschichtet sind.

18. Abschirmungsanordnung nach Anspruch 17, dadurch gekennzeichnet, daß die Beschichtung im Flammspritzverfahren aufgebracht ist.

19. Abschirmungsanordnung nach Anspruch 17, dadurch gekennzeichnet, daß die Beschichtung durch einen mit dem Granulat oder Pulver vermischten Kleber auf Kunststoffbasis aufgebracht ist.

20. Abschirmungsanordnung nach einem der vorhergehenden Ansprüche, dadurch gekennzeichnet, daß das Schirmungsmaterial unmagnetisch ist.

21. Abschirmungsanordnung nach einem der Ansprüche 17 bis 20, dadurch gekennzeichnet, daß die Beschichtung mit einer Schutzschicht aus leitendem Lack oder leitendem Kunststoff versehen ist.

22. Abschirmungsanordnung nach einem der vorhergehenden Ansprüche, dadurch gekennzeichnet, daß mindestens zwei leitenden Schichten im Abstand voneinander an dem Anpreßrahmen angeordnet sind, die aus unterschiedlichen Schirmungsmaterialien bestehen.

## Claims

1. Screening arrangement for shielding against electromagnetic waves, electrical pulses and/or electrical radiation, intended for openings, preferably window openings (3), of screened rooms, consisting of at least one conductive layer (10) covering the opening and conductively connected to a conductive surround (4) of the opening (3),
**characterised in that**
the surround consists of a contact frame (4) conductively connected to the screening of the room, that a press-fit push-on frame (8, 20, 50) can be pushed onto the contact frame (4, 54) by a push-on device (19), and that the push-on frame is provided with a screen or a sheet of shielding material or with a shielding coating to form the conductive layer (10) or that the push-on frame presses the screen (10, 23) or sheet forming the conductive layer (10) conductively against the contact frame (4).

2. Screening arrangement according to Claim 1, characterised in that the conductive layer (10) is designed as a flexible shielding screen (10, 23) which can be wound onto a winding shaft (9) mounted above the opening, and which can be unwound from this, and that the unwound shielding screen (10, 23) can be pressed by the push-on frame (8, 20, 50) so as to clamp it against the contact frame (4).

3. Screening arrangement according to Claim 2, characterised in that the push-on frame (8) is located on guide pins (7) of the contact frame (4), which pass through holes in the push-on frame (8), and can be pressed against the shielding screen (10, 23) resting against the contact frame (4) by a clamping device (19).

4. Screening arrangement according to one of Claims 1 to 3, characterised in that the contact frame (4) and the push-on frame (8) are provided with peripheral, spring-loaded contact strips (12) which are flush with one another in the plan view.

5. Screening arrangement according to Claim 2, characterised in that the push-on frame (20) is provided with a conductive overlay consisting of the shielding screen (10, 23) and with a surrounding groove (28) open towards the contact frame (25) which can be fitted to a tongue (26) surrounding the contact frame (25), and that springy contact strips (29, 30) attached to the flanks of the groove engage with preload against the tongue (26) as this is introduced into the groove (28).

6. Screening arrangement according to Claim 5, characterised in that the push-on frame (20) is pivot-mounted along one edge of the opening at the wall of the room by means of hinges (21, 22).

7. Screening arrangement according to Claim 6, characterised in that the hinges (21, 22) exhibit links (33) which are pivot-mounted at one end against the wall and at the other end are pivot-mounted to the push-on frame (20).

8. Screening arrangement according to Claim 7, characterised in that, connected to the push-on frame (20) or with the joint element (32) connected to this, is a bar or plate-shaped projection (36) directed against joint element (31) secured to the wall, between which projection (36) and a retainer (37) integral with the link (33) is clamped a compression spring (38), the effort of which tends to swing the link (33) into its stop position parallel to the push-on frame (20).

9. Screening arrangement according to Claim 7 or 8, characterised in that, arranged in a hole (39) of the moving hinge portion (32) connected to the push-on frame (20) is a spring-loaded pin (41) which is supported by a bearing surface (43) integral with the link (33), and which endeavours to swing the push-on frame (20) around an angle to the link, so that the push-on frame (20) is located in a plane parallel to the contact frame (25) just before reaching its closed position.

10. Screening arrangement according to Claim 1, characterised in that the push-on frame (50) provided with a conductive cover consisting of the shielding screen may be sunk into a recess (51) of a wall above or below the opening in the manner of a sliding window, and is provided with projections (52) with wedge-shaped angled surfaces (53) which are supported by complementary, wedge-shaped angled surfaces (56) of the contact frame (54) or of the wall such that the push-on frame (50) and the contact frame (54) are pressed against one another by the action of gravity.

11. Screening arrangement according to Claim 10, characterised in that the contact frame (54) and/or the push-on frame (50) are provided with springy contact strips around their periphery.

12. Screening arrangement according to Claim 2, characterised in that the push-on frame (8, 20, 50) provided with the cover consisting of the shielding screen (10, 23) runs in mutually parallel guide rails (63, 64) of the wall which, between them, enclose the opening, so as to enable sliding between a position above or below the opening and a position covering the opening.

13. Screening arrangement according to Claim 12, characterised in that the guide rails (63, 64) extend into the ceiling area so that the push-on frame can be slid to an inactive position parallel with the ceiling.

14. Screening arrangement according to Claim 12 or 13, characterised in that the push-on frame is guided by rollers (61, 62) or gliding pads (61, 62) in a guideway (63, 64) with an essentially rectangular profile, which is provided with slots for pins carrying the rollers or gliding pads, and that the push-on frame is provided with lateral contact spring strips (65, 66) which maintain a sliding contact with the guideway profile.

15. Screening arrangement according to one of the preceding claims, characterised in that the contact spring strips (65, 66) consist of adjacent springy contact leaves of screening material with central bowed portions.

16. Screening arrangement according to one of Claims 1 to 14, characterised in that the contact spring elements (65, 66) consist of tubes or round sections with sheaths of braided wire.

17. Screening arrangement according to one of Claims 1 to 16, characterised in that the shielding screen (10, 23) consists of a woven or knitted fabric or a textile sheet of glass fibres, plastic threads and/or wire which are coated on one or both sides with a powder and/or granulate of screening material.

18. Screening arrangement according to Claim 17, characterised in that the coating is applied using the flame spraying process.

19. Screening arrangement according to Claim 17, characterised in that the coating is applied using a resin-based adhesive mixed with the granulate or powder.

20. Screening arrangement according to one of the preceding claims, characterised in that the screening material is non-magnetic.

21. Screening arrangement according to one of Claims 17 to 20, characterised in that the coating is provided with a protective layer of conductive paint or conductive plastics.

22. Screening arrangement according to one of the preceding claims, characterised in that at least two conductive layers are arranged at a distance from each other on the push-on frame and consist of different screening materials.

## Revendications

1. Dispositif de blindage contre les ondes électromagnétiques, les impulsions électriques et/ou le rayonnement électrique, des ouvertures, de préférence des ouvertures de fenêtre (3), de locaux blindés au moyen d'un blindage consistant au moins en une couche conductrice (10) recouvrant l'ouverture, qui est reliée de manière à conduire à un encadrement conducteur (4) de l'ouverture (3),
caractérisé en ce que
l'encadrement consiste en un cadre de contact (4) relié de manière conductrice avec le blindage du local, qu'un cadre de pression (8, 20, 50) peut être pressé au moyen d'un dispositif de pression contre le cadre de contact (4, 54) et que le cadre de pression est pourvu d'une tenture ou d'une feuille en matériau blindant ou d'un enduit blindant formant la couche conductrice (10) ou que le cadre de pression presse la tenture (10, 23) formant la couche conductrice (10) ou la feuille formant la couche conductrice de manière à conduire, contre le cadre de contact (4).

2. Dispositif de blindage selon la revendication 1, caractérisé en ce que la couche conductrice (10) est formée comme tenture de blindage (10, 23) souple, qui peut être enroulée autour d'un arbre d'enroulement (9) logé au-dessus de l'ouverture et dont elle peut être dévidée, et que la tenture de blindage (10, 23) dévidée peut être pressée au moyen du cadre de pression (8, 20, 50) de manière à être serrée contre le cadre de contact (4).

3. Dispositif de blindage selon la revendication 2, caractérisé en ce que le cadre de pression (8) est guidé sur des pivots de guidage (7) du cadre de contact (4), qui traversent des alésages du cadre de pression (8), et peut être pressé contre la tenture de blindage (10, 23) s'appuyant contre le cadre de contact (4) au moyen d'un dispositif de serrage (19).

4. Dispositif de blindage selon l'une quelconque des revendications 1 à 3, caractérisé en ce que le cadre de contact (4) et le cadre de pression (8) sont pourvus sur leur pourtour de baguettes de contact à ressort (12) qui vues d'en-haut sont alignées l'une sur l'autre.

5. Dispositif de blindage selon la revendication 2, caractérisé en ce que le cadre de pression (20) est pourvu de manière à conduire d'un écran consistant dans la tenture de blindage (10, 23) et une rainure sur tout le pourtour ouverte vers le cadre de contact (25), qui peut être posée sur une barrette (26) s'étendant sur tout le pourtour du cadre de contact (25), et que des baguettes de contact à ressort (29, 30) montées avec précontrainte sur les flancs de la rainure reposent contre la barrette (26) glissée dans la rainure (28).

6. Dispositif de blindage selon la revendication 5, caractérisé en ce que le cadre de pression (20) dans la zone d'un bord de l'ouverture est monté par articulation moyennant des bandes charnières (21, 22) à la paroi du local.

7. Dispositif de blindage selon la revendication 6, caractérisé en ce que les bandes charnières (21, 22) présentent des bras (33) qui d'une part sont reliés par une articulation à la paroi et d'autre part par une articulation au cadre de pression (20).

8. Dispositif de blindage selon la revendication 7, caractérisé en ce qu'une projection (36) sous forme de barrette ou de plaque dirigée contre la pièce articulée (31) fixée à la paroi est reliée au cadre de pression (20) ou à la pièce articulée reliée à ce dernier (32), projection entre laquelle et un aboutement (37) du bras (33) un ressort de pression (38) est serré qui a tendance à basculer le bras (33) dans sa position de butée parallèle au cadre de pression (20).

9. Dispositif de blindage selon les revendications 7 ou 8, caractérisé en ce que dans un alésage (39) un axe à ressort (41) est disposé dans la partie charnière (32) mobile reliée au cadre de pression (20), qui repose sur une surface d'aboutement (43) du bras (33) et qui tente de basculer le cadre de pression (20) de manière à former un angle avec le bras de sorte que le cadre de pression (20), directement avant sa position de fermeture, se trouve dans un plan parallèle par rapport au cadre de contact (25).

10. Dispositif de blindage selon la revendication 1, caractérisé en ce que le cadre de pression (50) pourvu d'un écran conducteur consistant dans la tenture de blindage peut être escamoté dans un creux (51) d'une paroi au-dessus ou au-dessous de l'ouverture à la manière d'une fenêtre coulissante et est pourvu de projections (52) ayant des surfaces obliques biseautées (53) qui s'appuient contre des surfaces obliques biseautées complémentaires (56) du cadre de contact (54) ou contre la paroi de manière à ce que le cadre de pression (50) et le cadre de contact (54) sont pressés l'un contre l'autre sous l'effet de la pesanteur.

11. Dispositif de blindage selon la revendication 10, caractérisé en ce que le cadre de contact (54) et/ou le cadre de pression (50) sont pourvus sur tout leur pourtour de baguettes de contact à ressort.

12. Dispositif de blindage selon la revendication 2, caractérisé en ce que le cadre de pression (8, 20, 50) pourvu de l'écran consistant dans la tenture de blindage (10, 23) est guidé de manière à pouvoir être déplacé dans des rails de guidage (63, 64) réciproquement parallèles de la paroi, qui renferment entre eux l'ouverture, entre une position au-dessus ou au-dessous de l'ouverture et une position recouvrant l'ouverture.

13. Dispositif de blindage selon la revendication 12, caractérisé en ce que les rails de guidage (63, 64) s'étendent jusqu'à la zone du plafond de sorte que le cadre de pression peut être déplacé dans une position inactive parallèle au plafond.

14. Dispositif de blindage selon les revendications 12 ou 13, caractérisé en ce que le cadre de pression est guidé sur des roulettes (61, 62) ou des galets (61, 62) dans un guidage (63, 64) présentant un profilé essentiellement rectangulaire qui est pourvu de fentes pour les pivots portant les roulettes ou les galets et que le cadre de pression est pourvu de baguettes à ressort de contact (65, 66) latérales qui patinent sur le profilé de guidage.

15. Dispositif de blindage selon l'une quelconque des revendications précédentes, caractérisé en ce que les baguettes à ressort de contact (65, 66) consistent en lamelles de contact juxtaposées, élastiques en matériau blindant avec une partie médiane courbée en arc.

16. Dispositif de blindage selon l'une quelconque des revendications 1 à 14, caractérisé en ce que les baguettes à ressort de contact (65, 66) consistent en tuyaux ou profilés ronds enrobés d'un tissage en fil de fer.

17. Dispositif de blindage selon l'une quelconque des revendications 1 à 16, caractérisé en ce que la tenture de blindage (10, 23) consiste en un tissu, une matière tricotée ou une feuille textile en fibres de verre, ou fils plastiques et/ou fils de fer qui sont enduits d'un côté ou des deux d'un matériau de blindage en forme de poudre et/ou granulé.

18. Dispositif de blindage selon la revendication 17, caractérisé en ce que l'enduit est appliqué par procédé de pistolage à la flamme.

19. Dispositif de blindage selon la revendication 17, caractérisé en ce que l'enduit est appliqué avec le granulé ou la poudre mélangés à une colle à base plastique.

20. Dispositif de blindage selon l'une quelconque des revendications précédentes, caractérisé en ce que le matériau de blindage est non-magnétique.

21. Dispositif de blindage selon l'une quelconque des revendications 17 à 20, caractérisé en ce que l'enduit est pourvu d'une couche de protection en vernis conducteur ou plastique conducteur.

22. Dispositif de blindage selon l'une quelconque des revendications précédentes, caractérisé en ce qu'au moins deux couches conductrices sont disposées de manière espacée sur le cadre de pression, qui consistent en des matériaux de blindage différents.
